# EUROPEAN PATENT APPLICATION

(11) **EP 2 093 777 A1**
(43) Date of publication of application: **26.08.2009**
(21) Application number: 08151723.7
(22) Date of filing: 21.02.2008
(51) Int. Cl.: H01B 17/28, G01R 15/06

(54) **A bushing for a main high voltage conductor**

(71) Applicant: ABB Research Ltd., 8050 Zürich (CH)
(72) Inventor: Johansson, Kenneth, 722 28, VÄSTERÅS (SE)
(74) Representative: Dahlstrand, Björn

(57) **Abstract**

The present invention concerns a bushing (10) for a main conductor (12) comprising a number n of foils (F1, F2, F3, F4, F5) of electrically conductive material provided spaced from each other around an elongated volume stretching through the bushing and provided for the main conductor (12), and a mechanical fastening and electrical grounding body (16) encircling the foils and being provided with a measurement opening (18). The (n-1)^{th} foil (F4) from the volume in a direction (D) perpendicular to the direction of elongation of the volume includes an opening (24) and is electrically attached to the body (16). The n^{th} foil (F5) from the volume in the same direction, which is placed between the body (16) and the (n-1 )^{th} foil, is connected to a tap (20) via the measurement opening for enabling electrical measurements of the bushing. This type of bushing withstands fast high-voltage transients on the main conductor.

## Description

### Field of the Invention

The present invention relates to electric power devices and more particularly to a bushing for a main conductor to be used for interconnecting electric power devices.

### Background of the Invention

Bushings for high-voltage conductors are known to be used for enabling interconnection of electric power devices like for instance between such devices provided in separate rooms. Such a bushing is then typically provided in a wall between such rooms.

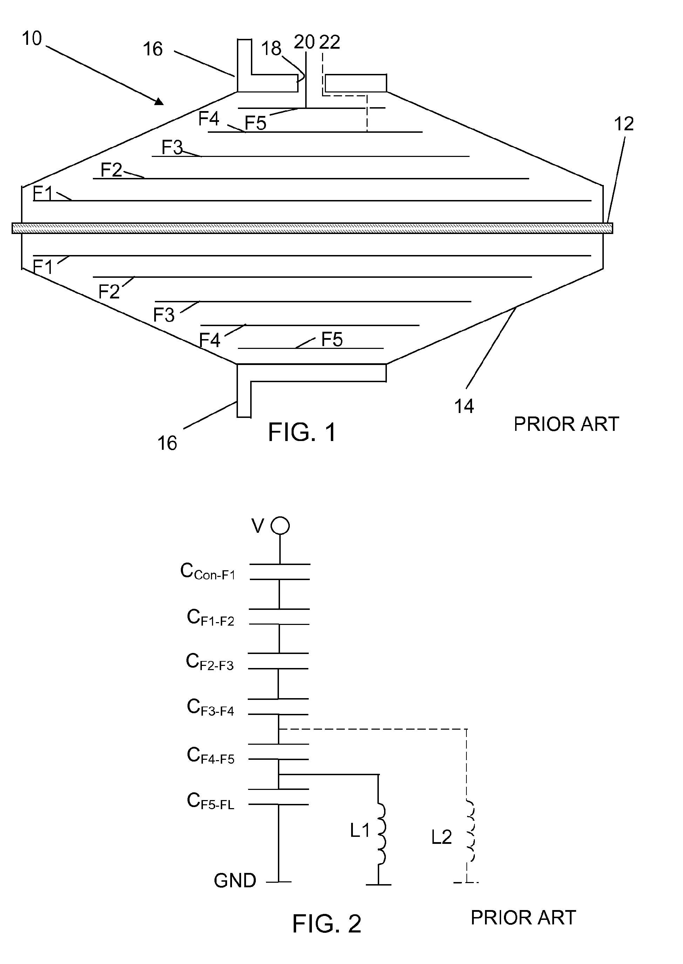

A known such bushing for a main electrical conductor is schematically shown in fig. 1, which shows a section of such a bushing taken along the length of a main electrical high-voltage conductor 12. The main conductor 12 passes through the middle of the bushing and therefore the bushing 10 surrounds the main electrical conductor 12. The main conductor 12 is furthermore radially surrounded by a number of foils F1, F2, F3, F4 and F5 of electrically conducting material provided in the interior of the bushing 10. In this known bushing 10 there is thus a first innermost foil F1, which surrounds the main conductor 12. A second foil F2 in turn surrounds the first foil F1. Thereafter follows a third foil F3 that surrounds the second foil F2. A fourth foil F4 surrounds the third foil F3. Finally a fifth and outermost foil F5 surrounds the fourth foil F4 and is connected to a flange 16 for grounding purposes. All of the foils are furthermore distanced from each other by gaps in the radial direction from the main conductor 12. It is here also known to provide one or more measurement taps 20 and 22 through providing additional electrical conductors to one F5 or two F5 and F4 of the outermost foils F5 and F4. These taps 20 and 22 are then accessible through a measurement opening 18 provided in the flange 16. The second tap 22 is here optional, which is indicated by dashed lines. The foils are finally surrounded by walls 14, which walls may be provided by a ceramic material or through an isolation or dielectric material if this isolation or dielectric material is solid. The taps are provided because it is in many cases of interest to measure various properties of the bushing, like its dielectric properties, for instance in order to see if it functions correctly or if it has become humid during transportation. During operation of the devices that the bushing is connected between, these taps are grounded, which may be done through sealing the measurement opening 18 with a sealing cap of the flange and connecting the taps 20 and 22 to the sealing cap. However, the additional electrical conductors that lead to the taps provide a parasitic inductance and the foils provide a series of capacitances.

An electric schematic diagram of a model of this known bushing is shown in fig. 2. As can be seen the different foils together make up a number of capacitances connected in series between a voltage V, which is provided by the main conductor, and ground, which is provided by the flange. There is thus a first capacitance C_{CON-F1} connected to the voltage V and formed by the first foil F1 and the main conductor, here denoted CON, a second capacitance C_{F1-F2} connected to the first capacitance C_{CON-F1} and formed by the first and second foils F1 and F2, a third capacitance C_{F2-F3} connected to the second capacitance C_{F1-F2} and formed by the second and third foils F2 and F3, a fourth capacitance C_{F3-F4} connected to the third capacitance C_{F2-F3} and formed by the third and fourth foils F3 and F4, a fifth capacitance C_{F4-F5} connected to the fourth capacitance C_{F3-F4} and formed by the fourth and fifth foils F4 and F5 and finally a sixth capacitance C_{F5-FL} connected between the fifth capacitance C_{F4-F5} and ground and formed by the fifth foil F5 and the flange, here denoted FL. The additional conductor connected between the fifth foil and the first measurement tap furthermore provides a first inductance L1 being connected in parallel with the sixth capacitance C_{F5-FL}, and thus being connected between ground and the junction point of the fifth and sixth capacitances C_{F4-F5} and C_{F5-FL}. The additional conductor connected between the fourth foil and the second measurement tap furthermore provides a second inductance L2 being connected between ground and the junction point of the fourth and fifth capacitances C_{F3-F4} and C_{F4-F5}. The grounding of these conductors is made when the cap closes the measurement opening. As can be understood through studying fig. 2 the fifth and sixth capacitances C_{F4-F5} and C_{F5-FL} form resonance circuits together with these inductances L1 and L2, which will resonate at certain frequencies. This means that if the electrical power supplied by the electrical conductor has transients, often denoted VFT (Very fast Transients) these transients may cause the resonance circuit to resonate, which in turn may lead to the bushing being destroyed, especially for high voltages. This is highly undesirable.

There is therefore a need for providing a new type of bushing of the above-described type, which solves the above-mentioned problem.

### Summary of the Invention

The present invention is directed towards solving the problem of stopping fast high-voltage transients on a main conductor from destroying a bushing provided with a measurement tap.

This problem is generally solved through a bushing having an elongated volume that is provided for a main conductor and that stretches through it, where an (n-1 )^{th} foil in a direction that is perpendicular to the direction of elongation of the volume includes an opening and is electrically attached to a mechanical fastening and electrical grounding body and an outermost n^{th} foil from the volume in the same direction that is placed between the body and the (n-1)^{th} foil is connected to a measurement tap via a measurement opening in the body.

One object of the present invention is thus to provide a bushing having a measurement tap, which bushing can withstand fast high voltage transients on a main conductor.

This object is according to the present invention solved through a bushing for a main conductor comprising:
a number n of foils of electrically conductive material provided spaced from each other around an elongated volume stretching through the bushing and provided for the main conductor, and
a mechanical fastening and electrical grounding body encircling the foils and being provided with a measurement opening,
wherein
the (n-1)^{th} foil from the volume in a direction that is perpendicular to the direction of elongation of the volume includes an opening and is electrically attached to the mechanical fastening and electrical grounding body, and
the n^{th} foil from the volume in the same direction, which foil is placed between the mechanical fastening and electrical grounding body and the (n-1)^{th} foil, is connected to a tap via the measurement opening, via which tap electrical measurements may be made of the bushing.

The present invention has a number of advantages. The bushing according to the present invention will withstand very fast transients. It will thus not be destroyed by high voltage transients on the main conductor. According to the invention it is also possible to make measurements both during operation of electric devices being connected via the bushing as well as when such devices are not being operated. It is also possible to make measurements of transients. The invention furthermore provides a much higher voltage division ratio than the prior art bushing and this is also done without needing a high capacitance.

Further objectives and advantages, as well as the structure and function of an exemplary embodiment will become apparent from a consideration of the description, drawings, and examples.

### Brief Description of the Drawings

The foregoing and other features and advantages of the invention will be apparent from the following, more particular description of an exemplary embodiment of the invention, as illustrated in the accompanying drawings wherein like reference numbers generally indicate identical, functionally similar, and/or structurally similar elements.
Fig. 1 shows a sectional view of a known type of bushing surrounding an electrical conductor, where the section has been taken along the length of the conductor,
Fig. 2 shows an electric circuit diagram of an electrical model of the known bushing;
Fig. 3 shows a sectional view of a bushing according to an embodiment of the present invention surrounding a main electrical conductor, where the section has been taken along the length of the conductor,
Fig. 4 shows a cross sectional-view of the bushing, where the section has been taken along lines A -A in fig. 3,
Fig. 5 shows an electric circuit diagram according to an electrical model of the bushing according to the present invention, and
Fig. 6 shows an electric circuit diagram, which has been simplified in relation to the circuit diagram in fig. 5.

### Detailed Description of Embodiments of the Invention

Embodiments of the invention are discussed in detail below. In describing embodiments, specific terminology is employed for the sake of clarity. However, the invention is not intended to be limited to the specific terminology so selected. While specific exemplary embodiments are discussed, it should be understood that this is done for illustration purposes only. A person skilled in the relevant art will recognize that other components and configurations can be used without parting from the spirit and scope of the invention.

Fig. 1 and 2 describe a prior art bushing and will therefore not be described any further.

A bushing for a main high-voltage conductor according to the present invention may for instance be used for enabling interconnection of electric power devices, like transformers and switch gears for instance between separate rooms. The bushing may for instance be provided in a wall between such rooms. It may also be provided on the casing of a transformer and on a conductor leading to a switch gear. A bushing can therefore be placed at several locations in relation to a conductor, of which the above given examples are just a few.

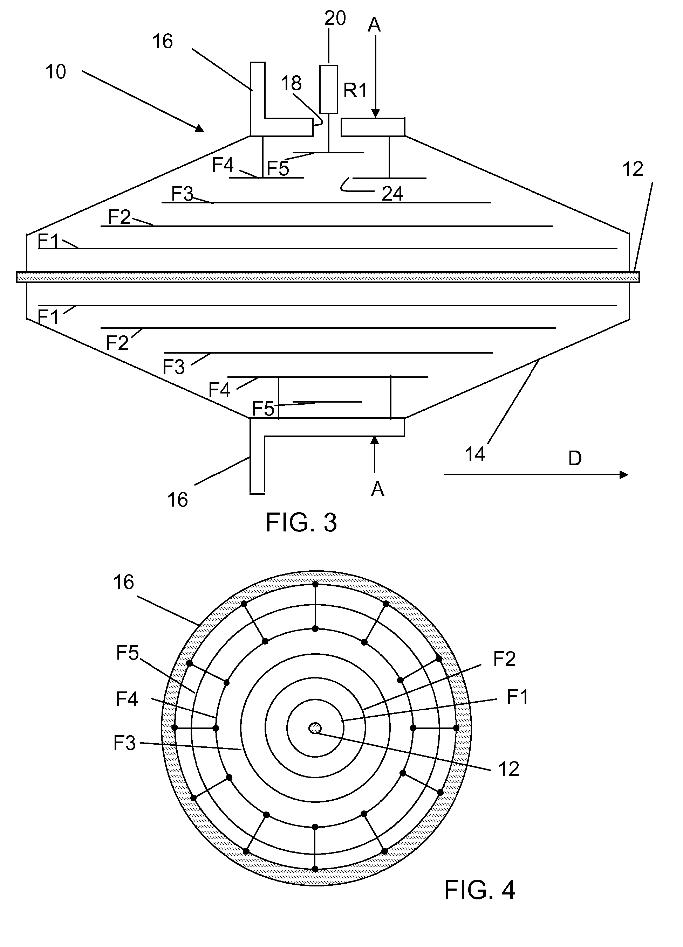

In fig. 3 there is schematically shown a bushing 10 according to an embodiment of the present invention for a main electrical conductor 12. Fig. 3 shows a section of this bushing 10 taken along the length of the main electrical conductor 12. Here the main electrical high-voltage conductor 12 is a part of the bushing 10 and stretches through an elongated volume provided for it in the middle of the bushing and having a direction of elongation D. This main conductor 12 is surrounded by a number of foils F1, F2, F3, F4 and F5. The foils are more particularly being provided round this elongated volume including the main conductor spaced from each other in a direction that is perpendicular to the direction of elongation D of this volume. This direction that is perpendicular to the direction D of elongation of the volume is in this embodiment a radial direction. In the bushing 10 there is thus a first innermost foil F1, which surrounds the main conductor 12. A second foil F2 in turn surrounds the first foil F1. Thereafter follows a third foil F3 that surrounds the second foil F2. A fourth foil F4 surrounds the third foil F3. Finally a fifth and outermost foil F5 surrounds the fourth foil F4. All of the foils are furthermore distanced from each other by gaps in the radial direction from the main conductor 12. Each foil is here formed as a hollow cylinder, with each foil having an increased diameter in relation to the previous foil closer to the main conductor 12 in the radial direction. A foil that is closer than a neighboring foil to the main conductor 12 in the radial direction furthermore has a longer extension in the direction D of elongation of the volume than this neighboring foil. Here the diameter and length are normally selected so that each foil should cover the same area. Therefore the lengths of the foils in the direction D of elongation of the volume decrease with the distance, here radial, to this volume. Each foil is made of an electrically conductive material, such as aluminum. The bushing is furthermore filled with isolation or dielectric material such as an oil, oil soaked paper or epoxy and thus also the spaces between the foils are filled with this material. The foils are surrounded by walls 14, which walls may be provided by a ceramic material if the isolation or dielectric material is fluid or through the isolation or dielectric material itself if this isolation or dielectric material is solid.

In the drawing five foils are shown in order to describe the functioning of the bushing 10. However it should be realized that many more foils may be used. There may generally speaking therefore be n foils in the bushing, where the foil closest to the main conductor is the first foil F1 and the outermost foil may be termed the n^{th} foil. In the present example n is five and therefore the fifth foil F5 is here the n^{th} foil. Similarly the (n-1)^{th} foil will there be the fourth foil F4 and the (n-2)^{th} foil the third foil F3. According to the principles of the present invention all but the n^{th} and (n-1)^{th} foil are "electrically floating", i.e. these foils lack electrical connection to any other electrically conducting material. However according to the present invention the (n-1)^{th} foil F4 is electrically connected to a mechanical fastening and electrical grounding body 16 in order to be grounded. This foil is thus the (n-1)^{th} foil from the above mentioned volume in a direction that is perpendicular to the direction D of elongation of the volume, which perpendicular direction is here a radial direction. The mechanical fastening and electrical grounding body is in the present embodiment realized as a flange. In this embodiment there are provided several electrical connections to the flange 16, where a first set is provided on one side of the measurement opening 18 and another set on the opposite side of the measurement opening. These sets are furthermore-provided in areas of the (n-1)^{th} foil F4 that lie beyond the n^{th} foil F5 along the length of the main conductor 12, i.e. in the direction D of elongation of the volume. The (n-1)^{th} foil and the flange therefore enclose the fifth foil through these grounding connections. This foil F4 is furthermore provided with an opening 24, i.e. a hole provided in the cylindrical foil, which opening may be aligned with the measurement opening 18, although this is by no means any requirement. The n^{th} and outermost foil F5 is furthermore connected to a measurement tap 20 provided via the measurement opening 18.Thus the n^{th} foil F5 from the volume in the above mentioned radial direction is placed between the flange 16 and the (n-1)^{th} foil F4. In this embodiment the n^{th} foil is connected to the tap via an additional conductor leading to a resistor R1. It should also here be realized that this resistor may be omitted in some embodiments of the invention.

The (n-1)^{th} foil is, as was mentioned above, being grounded. The nature of this grounding for one of the sets of electrical connections is shown in more detail in fig. 4, which shows a sectional view that is a cross-sectional view of the bushing 10, where the section has been taken along the line A-A indicated in fig. 3. As can be seen from this figure the (n-1)^{th} foil F4 includes a number of connections in one of the sets of electrical connections being symmetrically provided around the foil and being connected to the flange 16. They are thus provided circumferentially around this wound foil F4. As can be seen in fig. 3, one such set is furthermore provided at each end of the cylindrical foil, i.e. the sets are preferably provided on both sides of the n^{th} foil F5 and on both sides of the measurement opening.

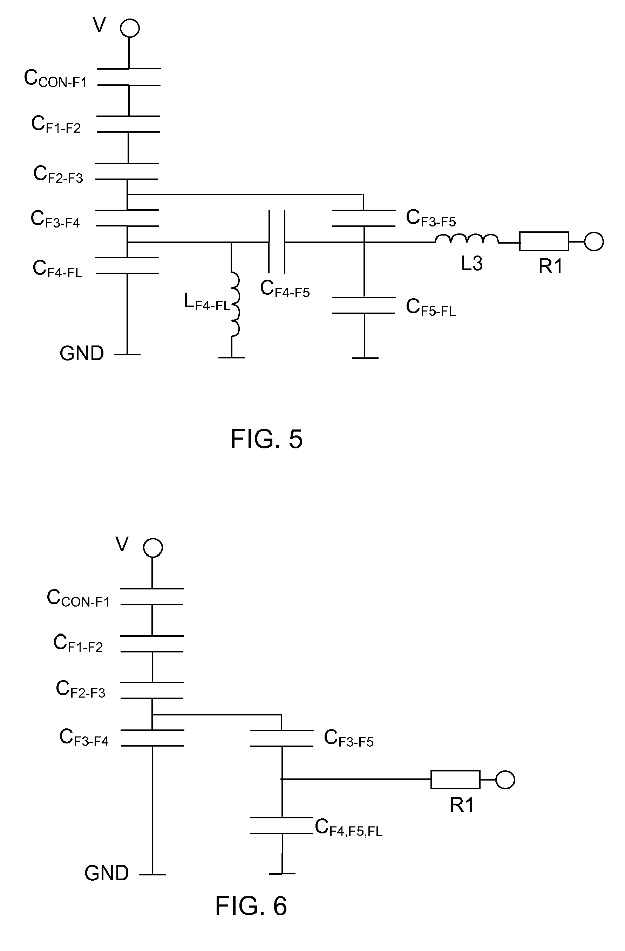

An equivalent electrical circuit diagram corresponding to the electrical circuit diagram in fig. 2, but for the bushing according to the present invention is shown in fig. 5. In the equivalent electrical circuit there is, in a similar way as in the circuit diagram for the known bushing shown in fig. 2, capacitances connected in series between a voltage V and ground, where the capacitances are realized through the use of the foils. The main conductor is here denoted CON and the flange is denoted FL. As in fig. 2 there is a first capacitance C_{CON-F1} connected to the voltage V and formed by the first foil F1 and the main conductor, a second capacitance C_{F1-F2} connected to the first capacitance C_{CON-F1} and formed by the first and second foils F1 and F2, a third capacitance C_{F2-F3} connected to the second capacitance C_{F1-F2} and formed by the second and third foils F2 and F3, a fourth capacitance C_{F3-F4} connected to the third capacitance C_{F2-F3} and formed by the third and fourth foils F3 and F4 and a fifth capacitance C_{F4-FL} connected to the fourth capacitance C_{F3-F4}. There is capacitive coupling between the fourth foil F4 and the flange FL. Therefore, unlike the fifth capacitance of fig. 2, this fifth capacitance C_{F4-FL} is formed by the (n-1)^{th} foil, here the fourth foil F4, and the flange. According to the present invention this (n-1)^{th} foil F4 is furthermore, as was described above, connected to the flange for grounding and the electrical connections used for this purpose provides an inductance L_{F4-FL} connected in parallel with the fifth capacitance C_{F4-FL}, i.e. connected between ground and the junction point of the fourth and fifth capacitances C_{F3-F4} and C_{F4-FL}. There is also a sixth capacitance C_{F4-F5} formed by the (n-1)^{th} F4 and the n^{th} foil, here the fifth foil F5. This sixth capacitance C_{F4-F5} is at a first end connected to the above mentioned junction point of the fourth and fifth capacitances C_{F3-F4} and C_{F4-FL} and at a second opposite end to a first end of an inductance L3. This inductance L3 is provided through the additional conductor leading to the measurement tap. Since there is an opening in the (n-1)^{th} foil F4, there is furthermore a capacitive connection between the (n-2)^{th}, here third foil F3, and the n^{th} foil F5, this capacitive connection is realized through a seventh capacitance C_{F3-F5} connected between the junction point of the third and fourth capacitances C_{F2-F3} and C_{F3-F4} and the junction point of the sixth capacitance C_{F4-F5} and the inductance L3. There is also a capacitive connection between the n^{th} foil F5 and the (grounded) flange. This capacitive connection is here realized as an eight capacitance C_{F5-FL} between ground and the junction point of the sixth capacitance C_{F4-F5} and the inductance L3. Finally the resistor R1 is connected to the additional conductor leading to the n^{th} foil F5, which in the circuit diagram is shown through the resistor R1 being connected between a second end of the inductance L3 and the measurement tap, where measurements of the bushing may be made.

The electric circuit diagram may be simplified. The simplified circuit diagram is shown in fig. 6. The inductance L_{F4-FL} is small and can because of the many parallel connections being provided between the flange 16 and the (n-1)^{th} foil F4 be seen as a direct grounding. This also makes it possible to remove the fifth capacitance C_{F4-FL}. The sixth and the eight capacitances C_{F4-F5} and C_{F5-FL} are therefore also connected in parallel and thus they may be expressed as a single capacitance C_{F4,F5,FL} being the sum of the sixth and eight capacitances C_{F4-F5} and C_{F5-FL}. Finally the impedance of the inductance L3 is also very small compared with the resistor R1 and may be removed. In this way the electric circuit diagram of fig. 6 is realized where a number of capacitances C_{CON-F1}, C_{F1-F2}, C_{F2-F3} and C_{F3-F4} are connected in series between the voltage V and ground and where the fourth capacitance C_{F3-F4} is the last. The seventh capacitance C_{F3-F5} is in this simplified circuit diagram at one end connected to the junction point of the third and fourth capacitances C_{F2-F3} and C_{F3-F4} and at the other end connected to a junction point between the capacitance C_{F4,F5,FL} and the resistor R1, with the other end of the capacitor C_{F4,F5,FL} being grounded. The other end of the resistor R1 leads to the measurement tap as in fig. 5.

As can be seen in fig. 6 there are no longer any inductors and therefore there is no resonance circuit. Hence the bushing according to the present invention will withstand VFT. In this way such high voltage transients on the main conductor do not destroy the bushing.

There is another way in which the bushing according to the invention can be seen. The n^{th} foil F5 can be seen as provided in a Faraday's cage that is provided through the (n-1)^{th} foil F4 and the flange. The n^{th} foil can here detect the electrical field provided through the opening in the (n-1 )^{th} foil and hence it is possible to measure various properties of the bushing. With this solution it is furthermore possible to provide measurements both during operation of the electric devices and when they are not being operated. It is also possible to make measurements of transients. The invention furthermore provides a much higher voltage division ratio than the prior art bushing and this is also done without needing a high capacitance. It is of course still possible to measure the various properties of the bushing, like its dielectric properties, for instance in order to see if it functions correctly or if it has become humid during transportation. The resistor, when it is includes has the further advantage of providing further protection and ensure that a further connection made to the measurement tap does not act as an inductor. The circumferential solution of grounding the (n-1)^{th} foil using two sets of electrical connections has the advantage of making the inductance between this foil and the flange very small.

It is according to the invention possible to leave the measurement opening open during operation of the devices. It does thus need to be sealed by a cap for safety purposes. This is possible both with and without the resistor. The reason that this can be done also without the resistor is that the first to (n-1)^{th} foils divide the voltage of the conductor to a low enough level that is not hazardous.

There are a number of changes that may be made to the first embodiment of the bushing according to the present invention. The number of foils may of course be varied. It is for instance possible to remove the resistor. Also the connection of the (n-1)^{th} foil to the flange can be varied in many ways. In its simplest form there is only one such connection. In a slight further variation there may be only two connections to the flange, one at each end of the n^{th} foil. It is of course possible with fewer and more such connections. It is for instance also possible with several connections at only one end of the n^{th} foil. The connections may furthermore be provided as detachable connections. They may thus be removed from the flange. In this regard they may be provided as auto shortening measuring connectors, where all are being removed from the flange and one then being connected to measuring equipment together with the measurement tap. Such connections can as an alternative also be provided in other ways, like for instance through a connection to an insulated ring around the flange. The ring can then be shortened to the flange with several screws.

In the prior art bushing there was a further optional measuring tap. Also such a further measuring tap may be provided in the bushing according to the present invention. This can be done through splitting the n^{th} foil in half in a direction perpendicular to direction of elongation of the volume so that two cylinders are provided which are separated from each other in the direction of elongation of the volume. Each of these foil halves can then be connected to a corresponding measurement tap, perhaps via a respective resistor. As an alternative it is also possible to split the n^{th} foil in the direction of elongation of the volume, so that two cylinder pieces are formed that are separated from each other by two gaps running in the direction of elongation of the volume, where they thus together encircle the volume. It is also possible to provide a cap that closes the measurement opening like in prior art devices. Another possible variation of the present invention is that the main conductor need not be a part of the bushing. It may be inserted in the above described volume and a capacitive connection to the first foil is obtained via a metallic tube, for instance of aluminum, when the main conductor is inserted in the volume. It should finally be realized that the foils do not need to be wound to a cylindrical shape, i.e. have circular cross-sections, but may be wound to have other shapes like be provided with elliptical or rectangular cross-sections.

The embodiments illustrated and discussed in this specification are intended only to teach those skilled in the art the best way known to the inventor to make and use the invention. Nothing in this specification should be considered as limiting the scope of the present invention. All examples presented are representative and non-limiting. The above-described embodiment of the invention may be modified or varied, without departing from the invention, as appreciated by those skilled in the art in light of the above teachings. It is therefore to be understood that, within the scope of the claims and their equivalents, the invention may be practiced otherwise than as specifically described.

## Claims

1. A bushing (10) for a main conductor (12) comprising:
a number n of foils (F1, F2, F3, F4, F5) of electrically conductive material provided spaced from each other around an elongated volume stretching through said bushing and provided for said main conductor (12), and
a mechanical fastening and electrical grounding body (16) encircling said foils and being provided with a measurement opening (18),
wherein
the (n-1)^{th} foil (F4) from said volume in a direction that is perpendicular to the direction of elongation of said volume includes an opening (24) and is electrically attached to said mechanical fastening and electrical grounding body, and
the n^{th} foil (F5) from said volume in the same direction, which foil (F5) is placed between said mechanical fastening and electrical grounding body and said (n-1)^{th} foil, is connected to a tap (20) via said measurement opening, via which tap electrical measurements may be made of the bushing.

2. The bushing (10) according to claim 1, wherein the (n-1)^{th} foil is detachably connected to the mechanical fastening and electrical grounding body.

3. The bushing (10) according to any previous claim, wherein the (n-1)^{th} foil (F4) includes several electrical connections to said mechanical fastening and electrical grounding body provided circumferentially around said foil.

4. The bushing (10) according to claim 3, wherein there is a first set of electrical connections circumferentially provided around said (n-1)^{th} foil on one side of the measurement opening and a second set of electrical connection points circumferentially provided around said (n-1)^{th} foil on the opposite side of the measurement opening.

5. The bushing (10) according to claim 4, wherein the (n-1)^{th} foil has a longer extension in the direction of elongation of said volume than the n^{th} foil and the first and second sets of electrical connections are provided on opposite sides of the n^{th} foil in the direction of elongation of said volume.

6. The bushing (10) according to any previous claim, wherein the n^{th} foil is made up of two pieces, provided around the main conductor at the same distance from it in a direction that is perpendicular to the direction of elongation of said volume, where said pieces are spaced from each other by at least one gap and each is connected to a respective measurement tap.

7. The bushing (10) according to any previous claim, further comprising a measurement resistor (R1) in or adjacent the measurement opening, where said n^{th} foil is connected to said tap via this measurement resistor.

8. The bushing (10) according to any previous claim, wherein the opening in the (n-1)^{th} foil is aligned with said measurement opening.

9. The bushing (10) according to any previous claim, wherein the length of the foils in the direction of elongation of said volume decrease with the distance to this volume.

10. The bushing (10) according to any previous claims, further including the main conductor in said volume.
